# EUROPÄISCHE PATENTSCHRIFT

(11) **EP 0 836 540 B1**
(45) Veröffentlichungstag und Bekanntmachung des Hinweises auf die Patenterteilung: **30.06.1999**
(21) Anmeldenummer: 96916139.7
(22) Anmeldetag: 21.05.1996
(51) Int. Cl.: B23P 15/24, G03F 7/00

(54) **VERFAHREN ZUR HERSTELLUNG VON FORMEINSÄTZEN**
PROCESS FOR MANUFACTURING MOULD INSERTS
PROCEDE POUR LA FABRICATION D'EMPREINTES DE MOULE

(30) Priorität: 01.07.1995 DE 19524099
(43) Veröffentlichungstag der Anmeldung: 22.04.1998
(73) Patentinhaber: Forschungszentrum Karlsruhe GmbH, 76133 Karlsruhe (DE)
(72) Erfinder: FAHRENBERG, Jens, D-76344 Eggenstein-Leopoldshafen (DE); BADE, Klaus, D-76135 Karlsruhe (DE); SCHOMBURG, Werner, D-76327 Pfinztal (DE)
(74) Vertreter: Rückert, Friedrich, Dr.
(86) Internationale Anmeldenummer: EP9602172
(87) Internationale Veröffentlichungsnummer: WO9702108

(56) Entgegenhaltungen:
- EP-A- 0 333 252
- EP-A- 0 547 371
- EP-A- 0 618 502
- US-A- 5 162 078

## Beschreibung

Die Erfindung betrifft ein Verfahren zur Herstellung von Formeinsätzen nach dem Oberbegriff des Patentanspruchs 1, wie es aus der EP-A-0 547 371 bekannt ist.

Durch Abformverfahren wie Spritzguß und Warmumformung werden Mikrostrukturen aus thermoplastischen Kunststoffen in großer Anzahl und zu günstigen Preisen gefertigt. Formgebendes Element bei diesen Abformverfahren sind Formeinsätze, die bei erhöhten Temperaturen mit dem Kunststoff in Berührung gebracht werden. Das Relief der durch Abformung hergestellten Mikrostrukturen ist deshalb wesentlich durch die dreidimensionale Form der Oberfläche des Formeinsatzes bestimmt.

In dem Beitrag "Molding of Threedimensional Microstructures by The LIGA Process" aus den Proceedings der Konferenz MEMS'92, die 1992 in Travemünde stattfand, ist auf den Seiten 202 bis 207 von den Autoren M. Harmening et. al. ein Verfahren zur Herstellung von Formeinsätzen mit mehreren Strukturebenen beschrieben. Bei diesem Verfahren wird zunächst durch Röntgentiefenlithografie und galvanische Abscheidung von Nickel ein Formeinsatz hergestellt, der zur Erzeugung einer einstufigen Mikrostruktur aus PMMA durch Abformung dient. Diese einstufige Mikrostruktur aus PMMA wird dann durch Röntgentiefenlithografie so strukturiert, daß eine weitere Strukturebene entsteht. Aus dieser Mikrostruktur wird durch erneute galvanische Abscheidung von Nickel ein Formeinsatz mit zwei Strukturebenen erzeugt. Durch wiederholte Anwendung dieses Verfahrens können komplex geformte Formeinsätze mit sehr kleinen Strukturabmessungen erzeugt werden. Nachteilig bei diesem Verfahren ist allerdings, daß mehrere Bestrahlungen an einem Synchrotron für die Herstellung erforderlich sind. Dadurch wird der Herstellungsaufwand vergleichsweise hoch.

In dem Beitrag "Microvalve System Fabricated by Thermoplastic Molding" von J. Fahrenberg et. al. aus dem Workshop Digest der Konferenz Micro Mechanics Europe '94, die 1994 in Pisa stattfand, ist auf den Seiten 178 - 181 ein durch Abformung erzeugtes Mikroventilsystem beschrieben, für dessen Herstellung ein Formeinsatz mit vier Strukturebenen verwendet wurde. Dieser Formeinsatz wurde durch die feinwerktechnische Bearbeitung einer Messingplatte gefertigt. Nachteilig bei diesem Verfahren ist allerdings, daß nicht so kleine Strukturen erzeugt werden können, weil z. B. die kleinsten zur Verfügung stehenden Fräsköpfe einen Durchmesser von ca. 300 µm aufweisen und damit gewisse Mindestabmessungen vorgegeben sind.

Die Erfindung hat die Aufgabe, ein Verfahren zur Verfügung zu stellen, mit dem Formeinsätze erzeugt werden können, die einerseits komplexe dreidimensionale Formen und andererseits sehr kleine Strukturen aufweisen.

Diese Aufgabe wird durch die Merkmale des Patentanspruchs 1 gelöst. Die Unteransprüche beschreiben vorteilhafte Ausgestaltungen des Verfahrens.

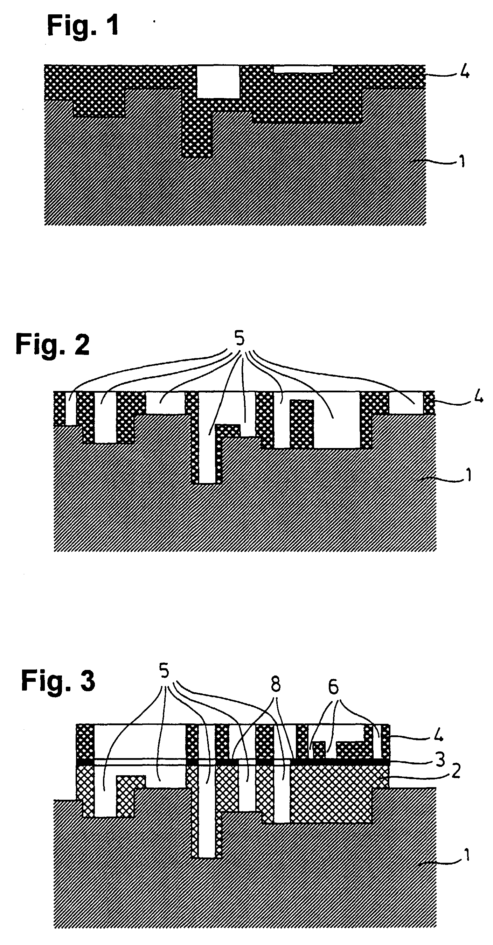

Die Erfindung wird im folgenden anhand von den Figuren 1 bis 3 mit Hilfe eines Ausführungsbeispiels näher erläutert. Dabei zeigen die Figuren schematisch einzelne Verfahrensschritte.

Das Anwendungsbeispiel beschreibt die Herstellung von Formeinsätzen mit mehreren Strukturebenen durch die Kombination von Röntgentiefenlithografie und feinwerktechnische Bearbeitung.

Die Oberfläche eines Kupfersubstrates 1 wird durch Fräsen und Bohren mit einer Mikrostruktur versehen (vgl. Figur 1). Auf dieses Substrat wird eine PMMA-Schicht 4 aufpolymerisiert und durch feinwerktechnische Bearbeitung ebenfalls mit mehreren Sturkturebenen versehen. Das PMMA 4 wird dann mit bekannten Methoden der Röntgentiefenlithografie justiert relativ zu den Strukturen im Substrat 1 strukturiert, wie es in Figur 2 schematisch gezeigt ist. Das Design der Strukturen ist dabei so gewählt, daß die laterale Form der Mikrostrukturen des Formeinsatzes durch die Belichtung des PMMAs 4 mit Röntgenstrahlung definiert wird. Wegen der größeren Auflösung der Röntgentiefenlithografie lassen sich dadurch Mikrostrukturen mit feineren lateralen Formen herstellen, als es feinwerktechnische Verfahren zulassen. Das Design wird darüber hinaus so gewählt, daß die Seitenwände der Strukturen durch PMMA gebildet werden, damit die galvanische Abscheidung vom Kupfersubstrat 1 aus aufwächst und eine vollständige galvanische Auffüllung der Hohlräume 5 mit Metall erreicht wird. Durch die unterschiedliche Tiefe der Hohlräume 5 im PMMA läßt es sich nicht vermeiden, daß die Oberkante des PMMAs bei der galvanischen Abscheidung zu unterschiedlichen Zeitpunkten erreicht wird. Daraus ergibt sich eine gewisse Einschränkung bezüglich der lateralen Abstände zwischen den Hohlräumen 5 und ihrer Tiefenunterschiede. Andererseits führt die hier beschriebene Vorgehensweise auf besonders einfache Weise zu Formeinsätzen mit mehreren Strukturebenen und kleinen lateralen Abmessungen.

Es ist auch möglich, wie im ersten Anwendungsbeispiel eine Epoxidharzschicht 2 mit einer Goldschicht 3 und einer darüber angebrachten PMMA-Schicht 4 auf ein feinwerktechnisch bearbeitetes Substrat 1 aufzubringen, feinwerktechnisch zu bearbeiten und dann die PMMA-Schicht durch Röntgentiefenlithografie zu strukturieren (vgl. Figur 3). In diesem Fall sind die lateralen Formen der Hohlräume 5 teilweise durch die feinwerktechnische Bearbeitung und teilweise durch die präzisere Röntgentiefenlithografie definiert. Durch eine entsprechende Wahl des Designs läßt sich sicherstellen, daß die Seitenwände der Hohlräume bis auf die elektrisch leitfähige Schicht 3 überall von elektrisch isolierendem Material gebildet werden.

Wenn die Hohlräume 6 an mindestens einer Stelle 8 mit den Hohlräumen 5 in direkter Verbindung stehen, ist es in vielen Fällen auch möglich, auf eine elektrisch leitfähige Schicht 3 zu verzichten.

## Patentansprüche

1. Verfahren zur Herstellung von Formeinsätzen durch Aufbringen einer elektrisch isolierenden und im folgenden lithographisch strukturierbaren Schicht (4) auf einem elektrisch leitfähigen und lithographisch nicht strukturierbaren Substrat (1), feinwerktechnische und lithographische Strukturierung der Probe, galvanische Abscheidung eines Metalls (7) in so entstandene Hohlräume (5) und anschließende Trennung des galvanisch abgeschiedenen Metalls vom Substrat und von den übrigen Strukturen, dadurch gekennzeichnet, daß das Substrat (1) vor dem Aufbringen der lithographisch strukturierbaren Schicht (4) feinwerktechnisch strukturiert wird.

2. Verfahren nach Anspruch 1, dadurch gekennzeichnet, daß auf dem elektrisch leitfähigen Substrat (1) nach der feinwerktechnischen Strukturierung des Substrats (1) und vor dem Aufbringen der lithographisch strukturierbaren Schicht (4) eine elektrisch isolierende, durch den nachfolgenden lithographischen Arbeitsschritt nicht strukturierbare Schicht (2) aufgebracht wird, und daß die lithographisch nicht strukturierbare Schicht (2) gemeinsam mit der lithographisch strukturierbaren Schicht (4) feinwerktechnisch strukturiert wird.

3. Verfahren nach Anspruch 2, dadurch gekennzeichnet, daß zwischen dem Aufbringen der lithographisch nicht strukturierbaren Schicht (2) und dem Aufbringen der lithographisch strukturierbaren Schicht (4) eine elektrisch leitfähige Schicht (3) aufgebracht wird.

## Claims

1. Method of manufacturing mould inserts by applying an electrically insulating and sequential lithographically structurable layer (4) to an electrically conductive and lithographically non-structurable substrate (1), by lithographically structuring the sample in a precision-engineered manner, by galvanically depositing a metal (7) in hollow cavities (5) thus produced, and by subsequently separating the galvanically deposited metal from the substrate and from the remaining structures, characterised in that the substrate (1) is structured in a precision-engineered manner prior to the application of the lithographically structurable layer (4).

2. Method according to claim 1, characterised in that, subsequent to the precision-engineered structuring of the substrate (1) and prior to the application of the lithographically structurable layer (4), an electrically insulating layer (2) is applied to the electrically conductive substrate (1), said layer (2) being non-structurable by the subsequent lithographic working step, and in that the lithographically non-structurable layer (2) is structured in a precision-engineered manner jointly with the lithographically structurable layer (4).

3. Method according to claim 2, characterised in that an electrically conductive layer (3) is applied between the application of the lithographically non-structurable layer (2) and the application of the lithographically structurable layer (4).

## Revendications

1. Procédé servant à fabriquer des noyaux de moule en mettant une couche (4) électriquement isolante et que l'on peut dans la suite structurer par lithographie sur un substrat (1) électriquement conducteur et que l'on ne peut pas structurer par lithographie, en structurant l'échantillon selon une technique mécanique de précision et par voie lithographique, en procédant à la précipitation galvanique d'un métal (7) dans des cavités ainsi formées (5) et en séparant ensuite le métal précipité galvaniquement du substrat et des autres structures,
caractérisé en ce que
le substrat (1) est structuré avant de mettre la couche (4), qu'on peut structurer par voie lithographique, selon une technique mécanique de précision.

2. Procédé selon la revendication 1,
caractérisé en ce qu'
- on met sur le substrat (1) électriquement conducteur après la structuration par une technique mécanique de précision du substrat (1) et avant d'avoir mis la couche (4), qu'on peut structurer par voie lithographique, une couche électriquement isolante, (2) qu'on ne peut pas structurer par la séquence suivante lithographique de travail, et
- la couche (2) qu'on ne peut pas structurer par voie lithographique est structurée en même temps que la couche (4) que l'on peut structurer par voie lithographique selon une technique mécanique de précision.

3. Procédé selon la revendication 2,
caractérisé en ce qu'
on met entre la mise de la couche (2), qu'on ne peut pas structurer par voie lithographique et la mise de la couche (4) qu'on peut structurer par voie lithographique une couche électriquement conductrice (3).
